# EUROPEAN PATENT APPLICATION

(11) **EP 4 730 935 A1**
(43) Date of publication of application: **22.04.2026**
(21) Application number: 24847678.0
(22) Date of filing: 30.04.2024
(51) Int. Cl.: H05K 7/20, H01Q 3/26

(54) **ANTENNA UNIT STRUCTURE APPLIED TO BASE STATION**

(30) Priority: 28.07.2023 CN 202310949098
(71) Applicant: ZTE CORPORATION, Shenzhen, Guangdong 518057 (CN)
(72) Inventor: ZHANG, Shuhan, Shenzhen, Guangdong 518057 (CN); HU, Maoxin, Shenzhen, Guangdong 518057 (CN); CHEN, Haibo, Shenzhen, Guangdong 518057 (CN); LIU, Liemiao, Shenzhen, Guangdong 518057 (CN); SUN, Weihua, Shenzhen, Guangdong 518057 (CN)
(74) Representative: Ziebig Hengelhaupt Intellectual Property Attorneys Patentanwaltskanzlei PartGmbB
(86) International application number: PCT/CN2024/090908
(87) International publication number: WO 2025/025712

(57) **Abstract**

Provided in the present application is an active antenna unit structure applied to a base station. The active antenna unit structure comprises: an upper housing assembly, a lower housing assembly, and a transceiver board and an antenna assembly, which are packaged between the upper housing assembly and the lower housing assembly. The upper housing assembly and the lower housing assembly are provided with heat dissipation teeth located in an external environment of packaging, the transceiver board is integrated with at least one of a transceiver chip, a power source, a filter and a power amplifier, and at least one of the transceiver chip, the power source, the filter and the power amplifier is in contact with the lower housing assembly and/or the upper housing assembly by means of a thermally conductive material, so as to dissipate heat by means of the heat dissipation teeth of the lower housing assembly and/or the upper housing assembly.

## Description

### CROSS-REFERENCE TO RELATED APPLICATIONS

The present application is proposed based on and claims priority to Chinese Application No. 202310949098.4, filed with the Chinese Patent Office on July 28, 2023, with the title "ANTENNA UNIT STRUCTURE APPLIED TO BASE STATION", the disclosure of which is hereby incorporated by reference in its entirety.

### TECHNICAL FIELD

The present application relates to the field of communication equipment technology, particularly to an active antenna unit structure applied to base stations.

### BACKGROUND

Massive MIMO technology is one of the key technologies in the 5G era, used to control the phase and amplitude of the transmitted (or received) signals of each antenna channel, thereby generating directional beams to enhance the signal in the beam direction and compensate for wireless propagation loss to obtain shaping gain. Shaping gain can be used to enhance cell coverage, such as wide area coverage, deep coverage, high-rise coverage, and other scenarios. However, MIMO technology also enables the entire machine to have higher output power and heat consumption, posing greater challenges to heat dissipation.

At present, common active antenna units in base stations are encapsulated and protected with components by a housing. With the continuous improvement of operators' requirements for miniaturization and lightweighting of base stations, the integration and heat flux density of the active antenna unit transceiver boards are constantly increasing, and the "thermal cascade effect" caused by heat dissipation is becoming more and more serious, which cannot meet the heat dissipation requirements of high-power base station products.

Therefore, in the trend of miniaturization and lightweighting of base stations, the technical problem to be solved in the present application is how to alleviate the "thermal cascade effect" caused by single-sided heat dissipation of the housing, so as to meet the heat dissipation requirements of high-power base station products with lighter overall weight and smaller overall size.

### SUMMARY

The embodiments of the present application provide an active antenna unit structure applied to a base station, comprises: an upper housing assembly, a lower housing assembly, and a transceiver board, which is encapsulated between the upper housing assembly and the lower housing assembly; wherein the upper housing assembly and the lower housing assembly are provided with heat dissipation teeth located in an external environment of encapsulation, the transceiver board is integrated with at least one of a transceiver chip, a power source, a filter and a power amplifier, or at least one of the transceiver chip, the power source, the filter or the power amplifier is in contact with the lower housing assembly and/or the upper housing assembly by means of a thermally conductive material, so as to dissipate heat by means of the heat dissipation teeth of the lower housing assembly and/or the upper housing assembly.

### BRIEF DESCRIPTION OF DRAWINGS

In order to more clearly illustrate the technical solution of the embodiments of the present application, the accompanying drawings required for describing the embodiments will be briefly introduced below. Obviously, the accompanying drawings in the following description are some embodiments of the present application. For those skilled in the art, other accompanying drawings can also be obtained based on these drawings without exerting creative efforts.
Fig. 1 is a three-dimensional schematic diagram of the active antenna unit structure of an embodiment of the present application.
Fig. 2 is a schematic diagram of the arrangement between the upper and lower housing assemblies and the heat dissipation teeth in the active antenna unit structure of an embodiment of the present application.
Fig. 3 is a two-dimensional schematic diagram of the heat dissipation of the transceiver board in the active antenna unit structure of an embodiment of the present application.
Fig. 4 is a schematic diagram of the structural relationship between the upper housing assembly and the antenna assembly in the active antenna unit structure of an embodiment of the present application.
Fig. 5 is a schematic diagram of the structural relationship between the upper housing assembly and the piezoelectric fan in the active antenna unit structure of an embodiment of the present application.

### DETAILED DESCRIPTION

As mentioned above, the commonly used active antenna units in base stations are encapsulated and protected by a single-sided housing with heat dissipation teeth to protect the transceiver board and achieve heat dissipation of on-board components. With the continuous improvement of operators' requirements for miniaturization and lightweighting of base stations, the integration and heat flux density of the transceiver boards are constantly increasing, and the "thermal cascade effect" caused by heat dissipation is becoming more and more serious, which cannot meet the heat dissipation requirements of high-power base station products.

Therefore, the present application aims to provide an active antenna unit structure applied to base stations, which can alleviate the adverse effects of "thermal cascade effect" on overall heat dissipation, and achieve efficient heat dissipation with lighter overall weight and smaller overall size. Specifically, the active antenna unit structure of the present application comprises: an upper housing assembly, a lower housing assembly, and a transceiver board, which is encapsulated between the upper housing assembly and the lower housing assembly. The upper housing assembly and the lower housing assembly are provided with heat dissipation teeth located in the external environment of encapsulation; the transceiver board is integrated with the main heat-generating components such as transceiver chip, power source, filter and power amplifier. Wherein these components are contact with the lower housing assembly and/or the upper housing assembly by means of the thermally conductive material, so as to dissipate heat to the external environment of the encapsulation by means of the heat dissipation teeth provided on the lower housing assembly and/or the upper housing assembly. Compared to traditional architecture active antenna units, the active antenna unit structure of the present application can effectively reduce the impact of "thermal cascade effect" on the overall heat dissipation of the machine, and more efficiently conduct the heat of components such as transceiver chips, power sources, filters, and power amplifiers to the external environment. Under the same heat consumption conditions, shorter heat dissipation teeth can meet the heat dissipation requirements, making the machine lighter in weight and smaller in size.

In order to enable those skilled in the art to better understand the technical solutions in this specification, the following will provide a clear and complete description of the technical solutions in the embodiments of the present application in conjunction with the accompanying drawings. Obviously, the described embodiments are only a part of the embodiments in this specification, not all of them. Based on the embodiments described in this specification, all other embodiments obtained by those skilled in the art without creative labor should fall within the scope of protection of this specification.

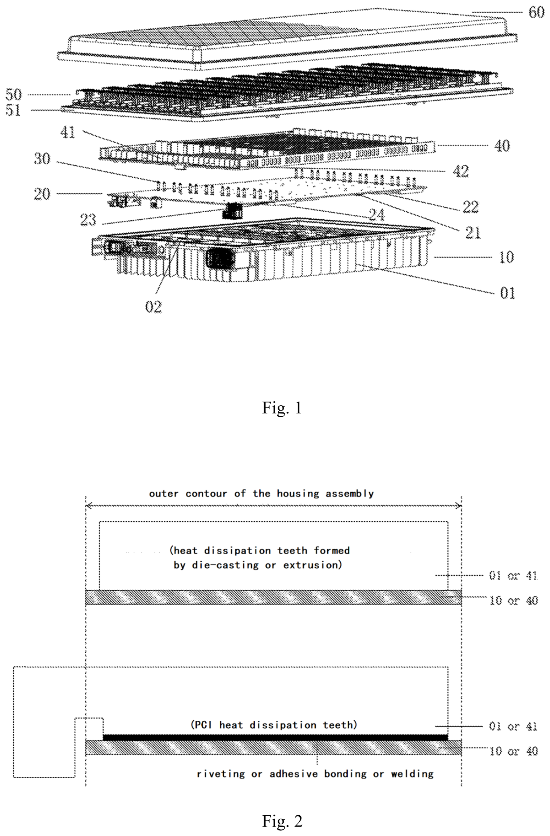

Fig. 1 is a schematic diagram of an active antenna unit structure according to an embodiment of the present application, comprising a lower housing assembly 10, a transceiver board 20, an RF connector assembly 30, an upper housing assembly 40, an antenna assembly 50, and an antenna cover 60.

Wherein the lower housing assembly 10 and the upper housing assembly 40 are encapsulated to form the housing main body of the active antenna unit structure. The transceiver board 20 is encapsulated in the internal space of the lower housing assembly 10 and the upper housing assembly 40. The upper housing assembly 40, the transceiver board 20, and the lower housing assembly 10 are fixed by waterproof screws 42 to maintain the sealing of the housing main body.

In order to meet the electromagnetic compatibility (EMC) requirements of the base station for the transceiver board 20, both the lower housing assembly 10 and the upper housing assembly 40 are made of conductive shielding materials, and the encapsulation contact area between the lower housing assembly 10 and/or the upper housing assembly 40 and the transceiver board 20 can be filled with conductive shielding adhesive.

Unlike traditional active antenna unit structures, this embodiment is equipped with heat dissipation teeth 01 and heat dissipation teeth 41 at the lower housing assembly 10 and the upper housing assembly 40, respectively. Wherein the heat dissipation teeth 01 and 41 are located in the external environment of the housing encapsulation for convective heat exchange with the outside.

As an illustrative example, please refer to the upper half part of Fig. 2. In this implementation, the lower housing assembly 10 and the heat dissipation teeth 01 are integrally formed through die casting or extrusion processes. Under integrated molding, the heat dissipation teeth 01 are distributed within the outer contour range of the lower housing assembly 10. Similarly, the upper housing assembly 40 and the heat dissipation teeth 41 can also be integrally formed through die-casting or extrusion processes, so that the heat dissipation teeth 41 are distributed within the outer contour of the upper housing assembly 4.

Alternatively, please refer to the lower half part of Fig. 2. In this implementation, the heat dissipation teeth 01 are made using Phase Change Inhibited (PCI) thermal conduction technology and are fixed to the lower housing assembly 10 by means of any one of riveting, adhesive bonding, and laser welding; wherein, in order to improve the heat dissipation effect of the heat dissipation teeth 01, the heat dissipation teeth 01 are appropriately extended from the main structure of the lower housing assembly 10 to increase the heat dissipation area. Similarly, the heat dissipation teeth 41 can also be made using PCI thermal conduction technology and fixed to the upper housing assembly 40 by means of any one of riveting, adhesive bonding, and laser welding, and appropriately extend from the main structure of the upper housing assembly 40.

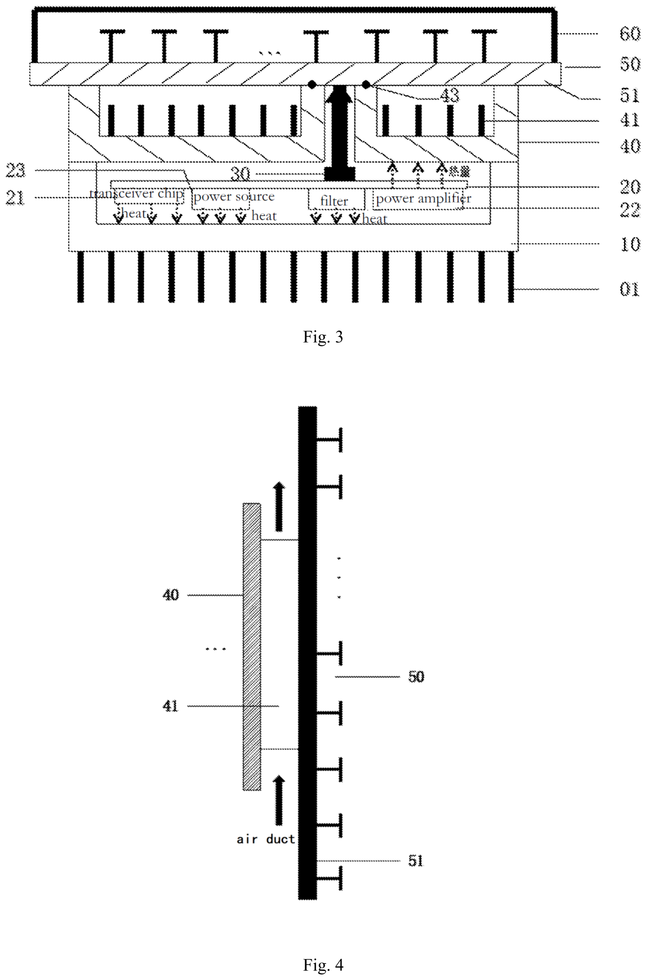

Furthermore, please refer to Fig. 3. The transceiver board 20 of this embodiment integrates the transceiver chip 21, power amplifier 22, power source 23, and filter 24 by means of surface mount welding. Wherein the antenna assembly 50 of this embodiment is located on the side of the upper housing assembly 40 facing away from the lower housing assembly 10. The upper housing assembly 40 is provided with a through-hole structure, and the RF connector 30 connects the transceiver board 20 and the antenna assembly 50 through the through-hole structure, forming signal interconnection between the transceiver board 20 and the antenna assembly 50.

In the structure shown in Fig. 3, the transceiver chip 21, the power amplifier 22, the power source 23 and the filter 24 contact with the lower housing assembly 10 and/or the upper housing assembly 40 by means of the thermally conductive materials (such as heat conducting gel, heat conducting gasket, silicone grease, etc.), so as to conduct heat to the heat dissipation teeth 11 or heat dissipation teeth 41 for heat dissipation towards the external environment of encapsulation.

As an illustrative introduction. In the active antenna unit structure, the heat generation of power amplifier 22 is significantly greater than that of transceiver chip 21, power source 23, and filter 24. In response to this feature, this embodiment can isolate the power amplifier 22 from other components for separate heat dissipation, thereby reducing the thermal cascade effect between the power amplifier 22 and other components and improving the heat dissipation density of the entire active antenna unit. That is, the transceiver chip 21, power source 23, and filter 24 are in contact with the lower housing assembly 10 by means of thermally conductive material. The heat generated by the transceiver chip 21, power source 23, and filter 24 is introduced into the lower housing assembly 10 and conducted to the external environment by means of the heat dissipation teeth 01; the power amplifier 22 is separately in contact with the upper housing assembly 40 by means of the thermally conductive material, and the heat generated is introduced into the upper housing assembly 40 by means of the transceiver board 20 and conducted to the external environment by means of the heat dissipation teeth 41.

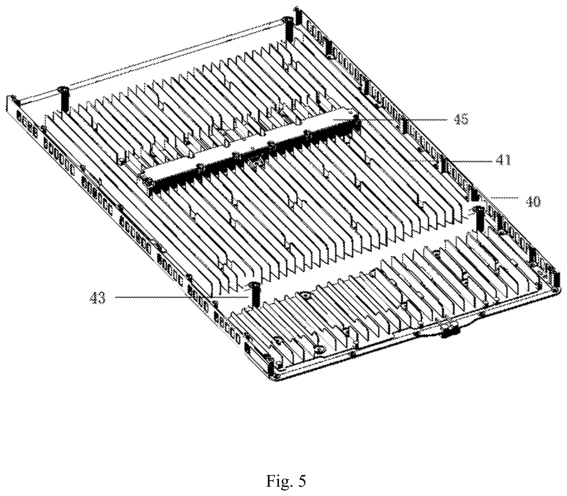

Furthermore, please refer to Figs. 4 and 5. In this embodiment, the heat dissipation teeth 41 of the upper housing assembly 40 are multiple and located between the antenna assembly 50 and the upper housing assembly 40. Wherein there are gaps between the multiple heat dissipation teeth 41 of the upper housing assembly 40 to form an air duct with chimney effect. The chimney effect refers to the phenomenon in which the temperature difference between the air inside and outside the structure creates a difference in air density, driving the high temperature air inside the structure to flow upwards, while the cold air outside the structure is continuously drawn in from the bottom. Based on the chimney effect, the air duct design allows the heat from the transceiver chip 21, power amplifier 22, power source 23, and filter 24 to be more efficiently conducted to the upper housing assembly 40.

It should be noted that in this embodiment, there should be a certain gap between the outer walls of the through-hole structure of the upper housing assembly 40, in order to maintain a certain amount of inlet and outlet air volume of the upper housing assembly 40 and improve the convective heat transfer effect.

In addition, in order to avoid the through-hole structure affecting the overall sealing of the housing, a sealing ring for waterproofing the through-hole structure can also be provided between the antenna assembly 50 and the upper housing assembly 40 in this embodiment. As an illustrative example, please refer to Figs. 1 and 5. The antenna assembly 50 of this embodiment is a substrate structure, which comprises an antenna substrate 51. Wherein the through-hole structures of the upper housing assembly 40 are multiple (the number is not limited), and each through-hole structure extends in the direction away from the lower housing assembly 10 to form a hole pillar 43. The upper housing assembly 40 is fixed against the antenna substrate 51 by means of the hole pillar 43 formed by the multiple through-hole structures.

In this embodiment, the hole pillar 42 is integrally die cast with the upper housing assembly 40, and the hole pillar 42 corresponds one-to-one with the sealing ring, that is, each sealing ring is set on the end face of its corresponding hole pillar 42 for contact with the antenna substrate 51. Based on the design of the hole pillar 42, the antenna substrate 51 serves as a sealing cover of the through-hole structure, and when used in conjunction with the sealing ring, it can effectively prevent water vapor from the external environment from entering the internal space of the housing encapsulation.

In addition, this embodiment can also install fans on the lower housing assembly 10 and/or the upper housing assembly 40 to dissipate heat through the fans. Here, taking the installation of a fan on the upper housing assembly 40 as an example. As shown in Fig. 5, the fan of this embodiment adopts a piezoelectric fan 45 that does not generate a magnetic field. The piezoelectric fan 45 is fixed to the upper housing assembly 40 by screws, and the air outlet faces the upper housing assembly 40, and is powered by the transceiver board 20. It should be noted that this embodiment does not specifically limit the way in which the transceiver board 20 supplies power to the piezoelectric fan 45. As one feasible solution, the power connector on the transceiver board 20 can be connected to the piezoelectric fan 45 via the through-hole structure of the upper housing assembly 40.

In summary, the active antenna unit structure of this embodiment integrates the main heat generating components on the transceiver board. While improving integration to save space, it also allows the components on the transceiver board to dissipate heat to the external environment by means of the heat dissipation teeth on different sides of the housing, which can to some extent reduce the thermal cascade effect caused by high integration between components.

In practical applications, the antenna unit structure of this embodiment utilizes shorter heat dissipation teeth to achieve efficient heat dissipation, making it particularly suitable for the trend of miniaturization of base stations. In addition, components such as power source, filter, and power amplifier are integrated on a single transceiver board, simplifying the difficulty of production and assembly of active antenna units. If the solution is finally implemented, it will have high practicality.

The specific embodiments of this specification have been described above. Other embodiments are within the scope of the appended claims. In some cases, the actions or steps described in the claims may be performed in a different order than in the embodiments and still achieve the desired results. In addition, the process depicted in the figures does not necessarily require a specific or continuous order to achieve the desired results. In some implementations, multitasking and parallel processing are also possible or may be advantageous.

The above are only embodiments of this specification and are not intended to limit this specification. For those skilled in the art, this specification can have various changes and variations. Any modifications, equivalent substitutions, improvements, etc. made within the spirit and principles of this specification shall be included within the scope of the claims of this specification. In addition, all other embodiments obtained by those skilled in the art without creative labor should fall within the scope of protection of this document.

## Claims

1. An active antenna unit structure applied to a base station, comprising: an upper housing assembly, a lower housing assembly, and a transceiver board, which is encapsulated between the upper housing assembly and the lower housing assembly;
wherein the upper housing assembly and the lower housing assembly are provided with heat dissipation teeth located in an external environment of encapsulation, the transceiver board is integrated with at least one of a transceiver chip, a power source, a filter or a power amplifier, and at least one of the transceiver chip, the power source, the filter or the power amplifier is in contact with the lower housing assembly and/or the upper housing assembly by means of a thermally conductive material, so as to dissipate heat by means of the heat dissipation teeth of the lower housing assembly and/or the upper housing assembly.

2. The active antenna unit structure according to claim 1, further comprising an antenna assembly and a RF connector;
wherein the antenna assembly is provided on the side of the upper housing assembly facing away from the lower housing assembly, and the upper housing assembly is provided with a through-hole structure, the RF connector connects the transceiver board and the antenna assembly through the through-hole structure.

3. The active antenna unit structure according to claim 2, wherein,
the heat dissipation teeth of the upper housing assembly are multiple and are arranged between the antenna assembly and the upper housing assembly, there is a gap left between the multiple heat dissipation teeth of the upper housing assembly to form an air duct with chimney effect.

4. The active antenna unit structure according to claim 2, further comprising a piezoelectric fan;
wherein the piezoelectric fan is provided on the upper housing assembly for dissipating heat from the upper housing assembly, and a power connector of the transceiver board is connected to the piezoelectric fan through the through-hole structure.

5. The active antenna unit structure according to any one of claims 1 to 4, wherein,
when the transceiver board is integrated with the transceiver chip, the power source, the filter, and the power amplifier at the same time, the power amplifier is in contact with the upper housing assembly by means of the thermally conductive material to dissipate heat by means of the heat dissipation teeth of the upper housing assembly; the transceiver chip, power source, and filter are in contact with the lower housing assembly by means of the thermally conductive material to dissipate heat by means of the heat dissipation teeth of the lower housing assembly.

6. The active antenna unit structure according to any one of claims 1 to 4, wherein,
the upper housing assembly and the lower housing assembly are both made of conductive shielding material, and the encapsulation contact area between the upper housing assembly and the transceiver board is filled with conductive shielding adhesive.

7. The active antenna unit structure according to any one of claims 1 to 4, wherein,
the encapsulation contact area between the lower housing assembly and the transceiver board is filled with conductive shielding adhesive.

8. The active antenna unit structure according to any one of claims 1 to 4, wherein,
the thermally conductive material comprises at least one of: heat conducting gel, heat conducting gasket or silicone grease.

9. The active antenna unit structure according to any one of claims 1 to 4, wherein,
the heat dissipation teeth of the upper housing assembly are fixed to the upper housing assembly by one of riveting, adhesive bonding and laser welding, and extend from the main structure of the upper housing assembly; and/or, the heat dissipation teeth of the lower housing assembly are fixed to the lower housing assembly by one of riveting, adhesive bonding, and laser welding, and extend from the main structure of the lower housing assembly.

10. The active antenna unit structure according to any one of claims 1 to 4, wherein,
the heat dissipation teeth of the upper housing assembly and the upper housing assembly are integrally formed through die-casting or extrusion processes; and/or, the heat dissipation teeth of the lower housing assembly and the lower housing assembly are integrally formed through die-casting or extrusion processes.
